# EUROPEAN PATENT APPLICATION

(11) **EP 4 699 733 A1**
(43) Date of publication of application: **25.02.2026**
(21) Application number: 24792734.6
(22) Date of filing: 18.04.2024
(51) Int. Cl.: B23K 26/066

(54) **LASER IRRADIATION DEVICE, LASER PROCESSING DEVICE, LASER PROCESSING METHOD, MASK INSTALLATION METHOD, LASER PROCESSING DEVICE INSTALLATION METHOD, AND MASK**

(30) Priority: 19.04.2023 WO PCT/JP2023/015669
(71) Applicant: Shin-Etsu Engineering Co., Ltd., Tokyo 101-0054 (JP)
(72) Inventor: OHTANI Yoshikazu, Annaka-shi, Gunma 379-0127 (JP); YAMAOKA Hiroshi, Yokohama-shi, Kanagawa 234-0053 (JP); KURATA Masami, Yokohama-shi, Kanagawa 234-0053 (JP); USAMI Taketo, Yokohama-shi, Kanagawa 234-0053 (JP)
(74) Representative: Meissner Bolte Partnerschaft mbB
(86) International application number: PCT/JP2024/015412
(87) International publication number: WO 2024/219462

(57) **Abstract**

The present invention is a laser irradiation apparatus for irradiating a body to be irradiated with a laser through a mask installed in a second optical functional unit, the apparatus including a first optical functional unit including a laser source, and the second optical functional unit for installing the mask having a pattern corresponding to a laser irradiation region of the body to be irradiated, in which the mask includes an effective area having the pattern corresponding to the laser irradiation region of the body to be irradiated, and is a quadrilateral having an outer edge of the mask formed by four sides, a longest side of which has a length of 800 mm or more, and the mask is arranged such that a normal to a surface on which the pattern is formed is oriented in a substantially horizontal direction in the second optical functional unit. This provides a low-height laser irradiation apparatus that suppresses an effect of deflection of the mask due to self-weight, which suppresses particle adhesion on the mask surface to reduce defect, thereby enabling highly accurate laser irradiation.

## Description

### TECHNICAL FIELD

The present invention relates to a laser irradiation apparatus, a laser processing apparatus, a method for laser processing, a method for installing a mask, a method for installing a laser processing apparatus, and a mask.

### BACKGROUND ART

Semiconductor package substrates are shifting in line with "More Than Moore" trend toward the trend of SoC (System on a Chip), in which the system is integrated into one chip, and are being actively developed along this trend.

Furthermore, the configuration of the semiconductor package substrate is becoming more complex and denser, and an apparatus using an excimer laser has been applied to the production of a base substrate of the semiconductor package substrate.

As the semiconductor package substrate becomes denser, the wiring of the semiconductor package substrate is also required to have fine patterning, and the wiring is also becoming more multilayered. Such thinning and multi-layering of the wiring leads to narrower and more complex line-and-space (L&S). As the wiring width becomes narrower, wiring resistance tends to increase.

In order to provide through-holes (VIAs) for establishing connections between wirings of multiple layers and to solve the problem of increased wiring resistance, in the production of the semiconductor package substrate, trenches (grooves) are provided in the substrate, and wirings are formed along the trenches. By forming such wiring, the cross-sectional area of the wiring can be increased, and therefore increase in wiring resistance can be suppressed.

An example of a method for producing such a semiconductor package substrate will be described below.

To begin with, build-up films are laminated on both surfaces of an inner layer substrate (core layer) made of glass epoxy resin material using a dedicated vacuum laminator. The surfaces of the build-up films obtained in this way are processed to provide the through-holes or trenches both described above, and then metal layers are formed by plating over the surfaces, thereby forming electrodes.

Meanwhile, in order to meet the demand for even higher density, the hole diameter of the required through-hole is becoming smaller. It is also required to form a through-hole having a cylindrical shape with a small difference between a Top diameter and a Bottom diameter (cylindrical VIA). The trench is also required to be a cylindrical trench.

In order to form the cylindrical hole or the cylindrical trench with high accuracy by performing processing as straight as possible with respect to the substrate, the use of a laser beam with high resolution and high energy density is effective. For such processing, it is more preferable to use the excimer laser rather than a solid-state laser apparatus. Although the excimer laser has a shallow depth of focus, the use of the excimer laser enables processing with high resolution and high energy density to form the cylindrical VIA or the cylindrical trench at a precise position with sharp edges.

Patent Document 1 discloses an invention regarding a laser drilling method and an apparatus thereof. For example, Claim 1 of Patent Document 1 recites a method for irradiating a processing region of a substrate to be processed with a linear or rectangular beam through a contact mask by a contact mask method, and scanning the contact mask with the linear or rectangular beam.

Patent Document 2 discloses an invention regarding a processing apparatus and a processing method for ablation processing. Claim 1 of Patent Document 2 recites that the processing apparatus for ablation processing is provided with a scanning mechanism for scanning with a line-shaped beam, in which a line beam forming unit, including an optical system for forming the line beam, is configured to move relative to the main body of the apparatus.

### CITATION LIST

### PATENT LITERATURE

Patent Document 1: JP 2001-79678 A
Patent Document 2: JP 2021-49560 A

### SUMMARY OF INVENTION

### TECHNICAL PROBLEM

In recent years, increasingly larger masks have come to be used in laser irradiation apparatuses employed in processing apparatuses, exposure apparatuses, and the like. In these conventional arts, the masks are often arranged horizontally so as to align with an installation surface of the apparatuses in the same horizontal direction. Accordingly, as the mask size increases, a problem arises, in which the mask deflects downward significantly due to self-weight. Consequently, this deflection may cause a problem in which image performance is degraded during exposure and processing accuracy is reduced during processing. In particular, the larger the mask size and the thinner the mask thickness, the more significant the problem becomes. To address this problem, the deflection while horizontally arranging can be suppressed to a certain extent by increasing the thickness of the mask in line with the enlargement of the mask to enhance its rigidity. However, the method, in which the thickness of the mask is increased, significantly increases the mask weight, which raises concerns about a degradation of handling performance, such as mask installation.

In addition, the extent of deflection of the mask varies depending on differences in materials or thickness. Accordingly, when different masks are used, a complex alignment of an entire optical system is required, resulting in a problem in terms of very labor-intensive adjustment.

In particular, under high NA (i.e., high resolution) and high-magnification exposure, an allowable value of deflection of the mask, which is allowed in laser processing, is stringent.

The present invention has been made to solve the above-described problem. An object of the present invention is to provide a laser irradiation apparatus capable of suppressing problems, such as deflection due to the self-weight of the mask, even when the large mask is used, and to provide a method for installing a mask that configures such a laser irradiation apparatus.

### SOLUTION TO PROBLEM

The present invention provides a laser irradiation apparatus for irradiating a body to be irradiated with a laser through a mask installed in a second optical functional unit, the apparatus comprising:
a first optical functional unit comprising a laser source; and
the second optical functional unit for installing the mask having a pattern corresponding to a laser irradiation region of the body to be irradiated, wherein
the mask includes an effective area having the pattern corresponding to the laser irradiation region of the body to be irradiated, and is a quadrilateral having an outer edge of the mask formed by four sides, a longest side of which has a length of 800 mm or more, and
the mask is arranged such that a normal to a surface on which the pattern is formed is oriented in a substantially horizontal direction in the second optical functional unit.

According to such a laser irradiation apparatus, an effect of deflection due to self-weight of the mask is suppressed, thereby enabling highly accurate laser irradiation. In addition, adhesion of particles on a mask surface can be suppressed, thereby reducing a particle-induced defect. Furthermore, since it is possible to align a large part of a long optical path with a horizontal plane, a height of the apparatus can be reduced.

The present invention can suppress deflection when the mask is installed by orienting the mask vertically, even when the mask is enlarged. More specifically, to achieve the above object, the present invention provides a laser irradiation apparatus for irradiating a body to be irradiated with a laser through a mask installed in a second optical functional unit, the apparatus comprising:
a first optical functional unit comprising a laser source; and
the second optical functional unit for installing the mask having a pattern corresponding to a laser irradiation region of the body to be irradiated, wherein
the mask includes an effective area having the pattern corresponding to the laser irradiation region of the body to be irradiated, and is a quadrilateral having an outer edge of the mask formed by four sides, a longest side of which has a length of 800 mm or more, and
the mask is arranged such that a normal to a surface on which the pattern is formed is oriented in a substantially horizontal direction in the second optical functional unit.

According to such a laser irradiation apparatus, an effect of deflection due to self-weight of the mask is suppressed, thereby enabling highly accurate laser irradiation. In addition, adhesion of particles on a mask surface can be suppressed, thereby reducing a particle-induced defect. Furthermore, since it is possible to align a large part of a long optical path with a horizontal plane, a height of the apparatus can be reduced.

In this case, the laser irradiation apparatus can employ the mask having a thickness of 10 mm or less at the effective area in a laser transmission direction.

Due to a thin thickness of the mask, the laser irradiation apparatus is easy to handle and low in cost, while reliably suppressing problems such as deflection due to the self-weight of the mask.

The present invention can be a laser processing apparatus for performing ablation processing on a surface of the body to be irradiated by irradiation energy of a laser beam, the apparatus comprising:
an irradiation processing unit comprising a stage configured to hold the body to be irradiated; and
the laser irradiation apparatus described above.

Accordingly, the laser processing apparatus is configured such that problems such as deflection of the mask due to a self-weight of the mask and adhesion of particles to the mask are suppressed.

In this case, the laser processing apparatus can be configured such that the second optical functional unit, the first optical functional unit, and the irradiation processing unit are separable from each other.

This facilitates separated transportation and enables a reduction in installation cost.

In this case, the laser processing apparatus can further comprise a mask changer capable of installing and removing the mask to and from the second optical functional unit.

This enables various patterns to be easily processed.

The present invention can provide a method for laser processing on a body to be irradiated, wherein
ablation processing is performed on the surface of the body to be irradiated using the laser processing apparatus described above.

Accordingly, highly accurate processing treatment can be performed while preventing deformation of the mask and adhesion of particles to the mask.

The present invention has been made to achieve the above object and provide a method for installing a mask to install the mask in a laser irradiation apparatus for irradiating a body to be irradiated with a laser through the mask installed in a second optical functional unit, the laser irradiation apparatus comprising:
a first optical functional unit comprising a laser source; and
the second optical functional unit for installing the mask having a pattern corresponding to a laser irradiation region of the body to be irradiated, wherein
the mask being used is a quadrilateral having an outer edge formed by four sides, a longest side of which has a length of 800 mm or more, and
the mask is installed in the second optical functional unit such that a normal to a surface on which the pattern is formed is oriented in a substantially horizontal direction.

According to such a method for installing a mask, highly accurate laser irradiation can be performed while suppressing an effect of deflection due to self-weight of the mask. In addition, the laser irradiation apparatus can be configured such that adhesion of particles on a mask surface can be suppressed, which reduces a defect caused by the particles. Furthermore, since it is possible to align a large part of a long optical path with a horizontal plane, a height of the apparatus can be reduced.

In this case, the method for installing a mask can be configured such that a mask having a thickness of 10 mm or less at the effective area in a laser transmission direction is used as the mask.

With the method for installing a mask according to the present invention, the laser irradiation apparatus can be configured such that the problems, such as the deflection due to the self-weight of the mask, are stably suppressed, while being easy to handle due to the thinness of the mask and low in cost.

In this case, the method for installing a mask can be configured such that the mask is installed using a mask changer.

Accordingly, the laser irradiation apparatus can be configured such that various patterns can be readily formed.

The present invention can provide a method for installing a laser processing apparatus, the laser processing apparatus including the laser irradiation apparatus and the irradiation processing unit comprising a stage configured to hold the body to be irradiated, wherein
the second optical functional unit, the first optical functional unit, and the irradiation processing unit are configured to be separable from each other, and the method comprises:
separately transporting the first optical functional unit, the second optical functional unit, and the irradiation processing unit to an installation location of the laser processing apparatus, respectively;
assembling the transported units into the laser processing apparatus integrated at the installation location of the laser processing apparatus; and
installing the mask in the second optical functional unit before or after the transportation according to the method for installing a mask described above.

Accordingly, a highly accurate laser irradiation can be performed while suppressing an effect of deflection due to self-weight of the mask. In addition, adhesion of particles on a mask surface can be suppressed, which reduces a defect caused by the particles. Furthermore, since it is possible to align a large part of a long optical path with a horizontal plane, a height of the apparatus can be reduced. As a result, installation costs of the laser processing apparatus can be reduced.

Moreover, the present invention provides a mask to be vertically installed in a laser irradiation apparatus, the mask having a quadrilateral shape and comprising an effective area that has a pattern corresponding to a laser irradiation region of a body to be irradiated, wherein
a longest side among four sides of the quadrilateral has a length of 800 mm or more.

With the mask according to the present invention, an effect of deflection due to self-weight is suppressed, thereby enabling highly accurate laser irradiation. In addition, adhesion of particles on a mask surface can be suppressed, thereby reducing a particle-induced defect. Furthermore, since it is possible to align a large part of a long optical path with a horizontal plane, a height of the apparatus can be reduced.

The present invention can suppress deflection when the mask is installed by orienting the mask vertically, even when the mask is enlarged. More specifically, to achieve the above object, the present invention provides a laser irradiation apparatus for irradiating a body to be irradiated with a laser through a mask installed in a second optical functional unit, the apparatus comprising:
a first optical functional unit comprising a laser source; and
the second optical functional unit for installing the mask having a pattern corresponding to a laser irradiation region of the body to be irradiated, wherein
the mask includes an effective area having the pattern corresponding to the laser irradiation region of the body to be irradiated, and is a quadrilateral having an outer edge of the mask formed by four sides, a shortest side of which has a length of 1000 mm or more, and
the mask is arranged such that a normal to a surface on which the pattern is formed is oriented in a substantially horizontal direction in the second optical functional unit.

According to such a laser irradiation apparatus, an effect of deflection due to self-weight of the mask is suppressed, thereby enabling highly accurate laser irradiation. In addition, adhesion of particles on a mask surface can be suppressed, thereby reducing a particle-induced defect. Furthermore, since it is possible to align a large part of a long optical path with a horizontal plane, the height of the apparatus can be reduced.

In this case, the laser irradiation apparatus can employ the mask having a thickness of 10 mm or less at the effective area in the laser transmission direction.

Due to a thin thickness of the mask, the laser irradiation apparatus is easy to handle and low in cost, while reliably suppressing problems such as deflection due to the self-weight of the mask.

The present invention can be a laser processing apparatus for performing ablation processing on a surface of the body to be irradiated by irradiation energy of a laser beam, the apparatus comprising:
an irradiation processing unit comprising a stage configured to hold the body to be irradiated; and
the laser irradiation apparatus described above.

Accordingly, the laser processing apparatus is configured such that problems such as deflection of the mask due to the self-weight of the mask and adhesion of particles to the mask are suppressed.

In this case, the laser processing apparatus can be configured such that the second optical functional unit, the first optical functional unit, and the irradiation processing unit are separable from each other.

This facilitates separated transportation and enables a reduction in installation cost.

In this case, the laser processing apparatus can further comprise a mask changer capable of installing and removing the mask to and from the second optical functional unit.

This enables various patterns to be easily processed.

The present invention can provide a method for laser processing on a body to be irradiated, wherein
ablation processing is performed on the surface of the body to be irradiated using the laser processing apparatus described above.

Accordingly, highly accurate processing treatment can be performed while preventing deformation of the mask and the adhesion of the particles to the mask.

The present invention can provide a laser exposure apparatus for performing exposure processing on the surface of the body to be irradiated by irradiation energy of a laser beam, the apparatus comprising:
an exposure unit comprising a stage configured to hold the body to be irradiated; and
the laser irradiation apparatus described above.

Accordingly, the exposure apparatus is configured such that problems such as deflection of the mask due to a self-weight of the mask and adhesion of particles to the mask are suppressed.

In this case, the laser exposure apparatus can be configured such that the second optical functional unit, the first optical functional unit, and the exposure unit are separable from each other.

This facilitates separated transportation and enables a reduction in installation cost.

In this case, the laser exposure apparatus can further comprise a mask changer capable of installing and removing the mask to and from the second optical functional unit.

This enables various exposure patterns to be readily formed.

The present invention can provide a method for laser exposure on a body to be irradiated, wherein
exposure processing is performed on the surface of the body to be irradiated using the laser exposure apparatus described above.

Accordingly, highly accurate exposure processing can be performed while preventing deformation of the mask and adhesion of particles to the mask.

The present invention has been made to achieve the above object and provide a method for installing a mask to install the mask in a laser irradiation apparatus for irradiating a body to be irradiated with a laser through the mask installed in a second optical functional unit, the laser irradiation apparatus comprising:
a first optical functional unit comprising a laser source; and
the second optical functional unit for installing the mask having a pattern corresponding to a laser irradiation region of the body to be irradiated, wherein
the mask being used is a quadrilateral having an outer edge formed by four sides, a shortest side of which has a length of 1000 mm or more, and
the mask is installed in the second optical functional unit such that a normal to a surface on which the pattern is formed is oriented in a substantially horizontal direction.

According to such a method for installing a mask, highly accurate laser irradiation can be performed while suppressing an effect of deflection due to self-weight of the mask. In addition, the laser irradiation apparatus can be configured such that adhesion of particles on a mask surface can be suppressed, which reduces a defect caused by the particles. Furthermore, since it is possible to align a large part of a long optical path with a horizontal plane, a height of the apparatus can be reduced.

In this case, the method for installing a mask can be configured such that a mask having a thickness of 10 mm or less at the effective area in a laser transmission direction is used as the mask.

With the method for installing a mask according to the present invention, the laser irradiation apparatus can be configured such that the problems, such as the deflection due to the self-weight of the mask, are stably suppressed while being easy to handle due to the thinness of the mask and low in cost.

In this case, the method for installing a mask can be configured such that the mask is installed using a mask changer.

Accordingly, the laser irradiation apparatus can be configured such that various patterns can be readily formed.

The present invention can provide a method for installing a laser processing apparatus, the laser processing apparatus including the laser irradiation apparatus and the irradiation processing unit comprising a stage configured to hold the body to be irradiated, wherein
the second optical functional unit, the first optical functional unit, and the irradiation processing unit are configured to be separable from each other, and the method comprises:
separately transporting the first optical functional unit, the second optical functional unit, and the irradiation processing unit to an installation location of the laser processing apparatus, respectively;
assembling the transported units into the laser processing apparatus integrated at the installation location of the laser processing apparatus; and
installing the mask in the second optical functional unit before or after the transportation according to the method for installing a mask described above.

Moreover, the present invention can provide a method for installing a laser exposure apparatus, the laser exposure apparatus including the laser irradiation apparatus and the exposure unit comprising a stage configured to hold the body to be irradiated, wherein
the second optical functional unit, the first optical functional unit, and the exposure unit are configured to be separable from each other, and the method comprises:
separately transporting the first optical functional unit, the second optical functional unit, and the exposure unit to an installation location of the laser exposure apparatus, respectively;
assembling the transported units into the laser exposure apparatus integrated at the installation location of the laser exposure apparatus; and
installing the mask in the second optical functional unit before or after the transportation according to the method for installing a mask described above.

Accordingly, a highly accurate laser irradiation can be performed while suppressing an effect of deflection due to self-weight of the mask. In addition, adhesion of particles on a mask surface can be suppressed, which reduces a defect caused by the particles. Furthermore, since it is possible to align a large part of a long optical path with a horizontal plane, a height of the apparatus can be reduced. As a result, installation costs of the laser processing apparatus / the exposure apparatus can be reduced.

Moreover, the present invention provides a mask to be vertically installed in a laser irradiation apparatus, the mask having a quadrilateral shape and comprising an effective area that has a pattern corresponding to a laser irradiation region of a body to be irradiated, wherein
a shortest side among four sides of the quadrilateral has a length of 1000 mm or more.

With the mask according to the present invention, an effect of deflection due to self-weight is suppressed, thereby enabling highly accurate laser irradiation. In addition, adhesion of particles on a mask surface can be suppressed, thereby reducing a particle-induced defect. Furthermore, since it is possible to align a large part of a long optical path with a horizontal plane, a height of the apparatus can be reduced.

Moreover, the present invention provides a laser irradiation system for irradiating a body to be irradiated with a laser through a mask installed in a second optical functional unit, the system comprising:
a first optical functional unit comprising a laser source; and
the second optical functional unit for installing the mask having a pattern corresponding to a laser irradiation region of the body to be irradiated, wherein
the mask includes an effective area having the pattern corresponding to the laser irradiation region of the body to be irradiated, and is a quadrilateral having an outer edge of the mask formed by four sides, a shortest side of which has a length of 1000 mm or more, and
the mask is arranged such that a normal to a surface on which the pattern is formed is oriented in a substantially horizontal direction in the second optical functional unit.

With the laser irradiation system according to the present invention, an effect of deflection due to self-weight of the mask is suppressed, thereby enabling highly accurate laser irradiation. In addition, adhesion of particles on a mask surface can be suppressed, which reduces the defect caused by the particles. Furthermore, since it is possible to align a large part of a long optical path with a horizontal plane, a height of the laser irradiation system can be reduced.

### ADVANTAGEOUS EFFECTS OF INVENTION

As described above, according to the inventive laser irradiation apparatus and the laser irradiation system, the effect of the deflection due to the self-weight of the mask is suppressed, thereby enabling highly accurate laser irradiation. In addition, the adhesion of the particles on the mask surface can be suppressed, which reduces the defect caused by the particles. Furthermore, since it is possible to align the large part of the long optical path with a horizontal plane, the height of the apparatus can be reduced.

Moreover, the inventive laser processing apparatus / the exposure apparatus is configured such that problems such as the deflection of the mask due to the self-weight of the mask and the adhesion of particles to the mask are suppressed. According to the inventive method for laser processing / the method for exposure processing, highly accurate processing treatment / exposure processing can be performed while preventing the deformation of the mask and the adhesion of the particles to the mask.

Moreover, according to the inventive method for installing a mask, the highly accurate laser irradiation can be performed while suppressing the effect of the deflection due to the self-weight of the mask. In addition, the laser irradiation apparatus can be configured such that the adhesion of the particles on the mask surface can be suppressed, which reduces the defect caused by the particles. Furthermore, since it is possible to align the large part of the long optical path with a horizontal plane, the height of the apparatus can be reduced. According to the inventive method for installing a laser processing apparatus / the method for installing an exposure apparatus, highly accurate laser irradiation can be performed while suppressing the effect of the deflection due to the self-weight of the mask. In addition, the adhesion of the particles on the mask surface can be suppressed, which reduces the defect caused by the particles. Furthermore, since it is possible to align the large part of the long optical path with a horizontal plane, the height of the apparatus can be reduced. As a result, installation costs of the apparatus can be reduced.

According to the inventive mask, the effect of the deflection due to the self-weight of the mask is suppressed, thereby enabling highly accurate laser irradiation. In addition, the adhesion of the particles on the mask surface can be suppressed, which reduces the defect caused by the particles. Furthermore, since it is possible to align the large part of the long optical path with a horizontal plane, the height of the apparatus can be reduced.

### BRIEF DESCRIPTION OF DRAWINGS

[FIG. 1] is a view illustrating an example of a laser irradiation treatment apparatus (laser processing apparatus and exposure apparatus) including a laser irradiation apparatus according to the present invention.
[FIG. 2] is a conceptual view illustrating an arrangement of a mask according to the present invention.
[FIG. 3] is a schematic view illustrating an example of a mask.
[FIG. 4] is a view illustrating an example of a relation between a region to be processed and an irradiation area in a body to be irradiated.
[FIG. 5] is a view describing an example of superimposed irradiation in a uniaxial direction.
[FIG. 6] is a view describing an example of superimposed irradiation across first to third columns.
[FIG. 7] is a conceptual view of shaping a laser beam irradiation shape in an example of a shaping optical system.
[FIG. 8] is a schematic view illustrating a configuration example of a laser irradiation treatment apparatus (laser processing apparatus and exposure apparatus) including a laser irradiation apparatus according to the present invention.
[FIG. 9] is a schematic view describing an example of a vertical mask changer.
[FIG. 10] is a schematic view of a cassette housing apparatus that can be provided with an example of a vertical mask changer.

### DESCRIPTION OF EMBODIMENTS

As described above, a laser irradiation apparatus capable of suppressing problems such as deflection due to self-weight of a mask, even when a large mask is employed, and a method for installing a mask that configures such a laser irradiation apparatus have been desired.

To solve the above problem, the present inventors have earnestly studied and found out that by a laser irradiation apparatus for irradiating a body to be irradiated with a laser through a mask installed in a second optical functional unit, the apparatus including a first optical functional unit including a laser source, and the second optical functional unit for installing the mask having a pattern corresponding to a laser irradiation region of the body to be irradiated, in which the mask includes an effective area having the pattern corresponding to the laser irradiation region of the body to be irradiated, and is a quadrilateral having an outer edge of the mask formed by four sides, a longest side of which has a length of 800 mm or more, and the mask is arranged such that a normal to a surface on which the pattern is formed is oriented in a substantially horizontal direction in the second optical functional unit, the effect of the deflection due to self-weight of the mask is suppressed. As a result, highly accurate laser irradiation is enabled. In addition, adhesion of particles on the mask surface can be suppressed, which reduces the defect caused by the particles. Furthermore, since a large part of a long optical path can be aligned with a horizontal plane, a height of the apparatus can be reduced. This finding has led to the completion of the present invention.

Moreover, the present inventors found out that by a method for installing a mask to install the mask in a laser irradiation apparatus for irradiating a body to be irradiated with a laser through the mask installed in a second optical functional unit, the laser irradiation apparatus including a first optical functional unit including a laser source, and the second optical functional unit for installing the mask having a pattern corresponding to a laser irradiation region of the body to be irradiated, in which the mask being used is a quadrilateral having an outer edge formed by four sides, a longest side of which has a length of 800 mm or more, and the mask is installed in the second optical functional unit such that a normal to a surface on which the pattern is formed is oriented in a substantially horizontal direction, the laser irradiation apparatus can be configured to perform highly accurate laser irradiation while suppressing deflection due to self-weight of the mask. In addition, adhesion of particles on the mask surface can be suppressed, which reduces the defect caused by the particles. Furthermore, since a large part of a long optical path can be aligned with a horizontal plane, a height of the apparatus can be reduced. This finding has led to the completion of the present invention.

Moreover, the present inventors found out that by a laser irradiation apparatus for irradiating a body to be irradiated with a laser through a mask installed in a second optical functional unit, the apparatus including a first optical functional unit including a laser source, and the second optical functional unit for installing the mask having a pattern corresponding to a laser irradiation region of the body to be irradiated, in which the mask includes an effective area having the pattern corresponding to the laser irradiation region of the body to be irradiated, and is a quadrilateral having an outer edge of the mask formed by four sides, a shortest side of which has a length of 1000 mm or more, and the mask is arranged such that a normal to a surface on which the pattern is formed is oriented in a substantially horizontal direction in the second optical functional unit, the effect of the deflection due to self-weight of the mask is suppressed. As a result, highly accurate laser irradiation is enabled. In addition, adhesion of particles on the mask surface can be suppressed, which reduces the defect caused by the particles. Furthermore, since a large part of a long optical path can be aligned with a horizontal plane, a height of the apparatus can be reduced. This finding has led to the completion of the present invention.

Moreover, the present inventors found out that by a method for installing a mask to install the mask in a laser irradiation apparatus for irradiating a body to be irradiated with a laser through the mask installed in a second optical functional unit, the laser irradiation apparatus including a first optical functional unit including a laser source, and the second optical functional unit for installing the mask having a pattern corresponding to a laser irradiation region of the body to be irradiated, in which the mask being used is a quadrilateral having an outer edge formed by four sides, a shortest side of which has a length of 1000 mm or more, and the mask is installed in the second optical functional unit such that a normal to a surface on which the pattern is formed is oriented in a substantially horizontal direction, the laser irradiation apparatus can be configured to perform highly accurate laser irradiation while suppressing deflection due to self-weight of the mask. In addition, adhesion of particles on the mask surface can be suppressed, which reduces the defect caused by the particles. Furthermore, since a large part of a long optical path can be aligned with a horizontal plane, a height of the apparatus can be reduced. This finding has led to the completion of the present invention.

Hereinafter, the present invention will be described in detail. However, the present invention is not limited thereto.

### [Laser Irradiation Apparatus]

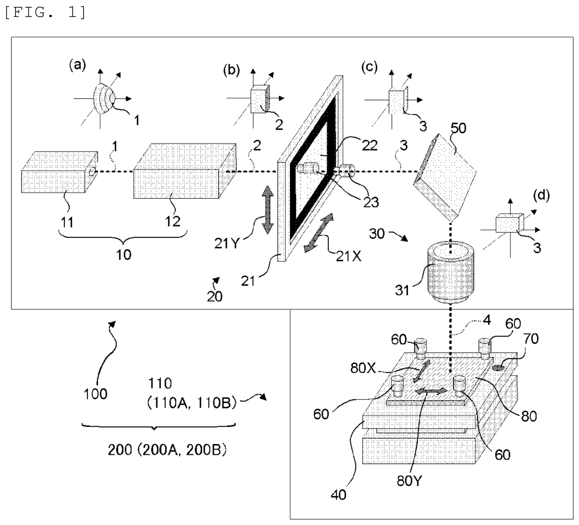

FIG. 1 is a schematic view illustrating an example of a laser processing apparatus including a laser irradiation apparatus according to the present invention. A laser irradiation apparatus 100 shown in FIG. 1 is provided with a first optical functional unit 10 including a laser source (laser oscillator) 11, and a second optical functional unit 20 for installing a mask having a pattern corresponding to a laser irradiation region of a body 80 to be irradiated. In addition, the laser irradiation apparatus 100 is a laser irradiation apparatus for irradiating the body 80 to be irradiated with a laser 1 from the laser source 11 through a mask 21 installed in the second optical functional unit 20.

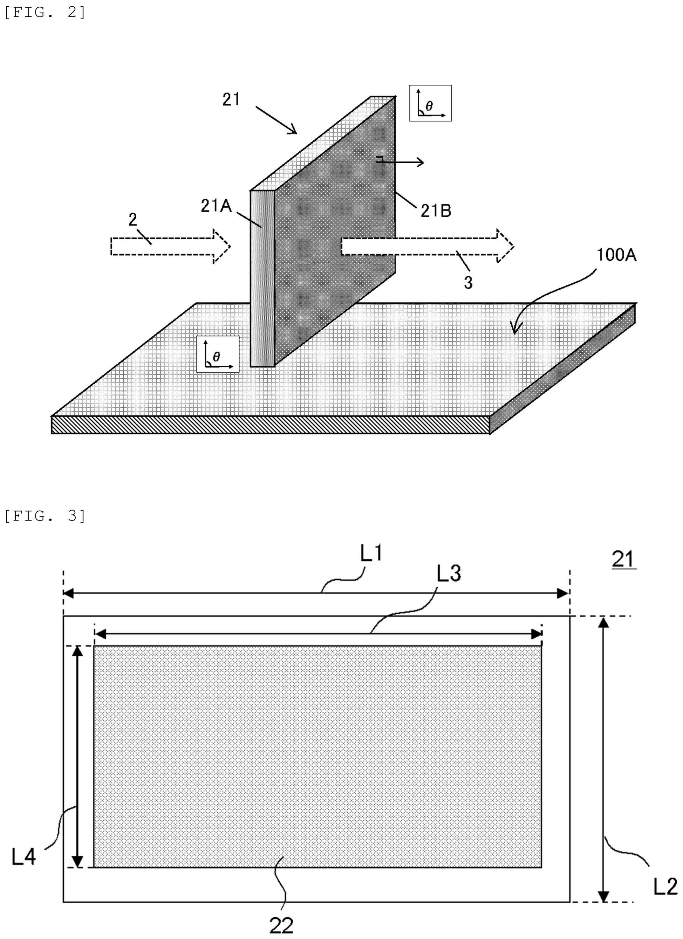

The mask 21 includes an effective area 22 having a pattern corresponding to the laser irradiation region of the body 80 to be irradiated. One embodiment of a mask according to the present invention includes the effective area 22 having a pattern corresponding to the laser irradiation region of the body 80 to be irradiated, where among four sides forming the outer edge of the mask, which has a quadrilateral shape, the longest side (the longer of L1 and L2 in FIG. 3) is 800 mm or more. The mask according to the present invention may have a ratio of the length of the longest side among four sides forming the outer edge of the quadrilateral mask 21 to a thickness of the effective area in a laser transmission direction (length / thickness) being 100 or more. This ratio is more preferably 150 or more, and further preferably 200 or more. The upper limit thereof is not particularly limited, but from a viewpoint of ease of handling, the upper limit is approximately 250. Note that when the mask is a square, the longest side among the four sides indicates the length of one side of the square.

Moreover, in another embodiment of a mask according to the present invention, the mask 21 includes the effective area 22 having a pattern corresponding to the laser irradiation region of the body 80 to be irradiated, where among four sides forming the outer edge of the mask, which has a quadrilateral shape, the shortest side (the shorter of L1 and L2 in FIG. 3) is 1000 mm or more. The mask according to the present invention may have a ratio of the length of the shortest side among four sides forming the outer edge of the quadrilateral mask 21 to a thickness of the effective area in a laser transmission direction (length / thickness) is 100 or more. This ratio is more preferably 150 or more, and further preferably 200 or more. The upper limit thereof is not particularly limited, but from a viewpoint of ease of handling, the upper limit is approximately 250. When the mask is a square, the shortest side among the four sides indicates the length of one side of the square.

In the present invention, the quadrilateral does not indicate a strictly quadrilateral shape, but may have four corners chamfered with straight lines or curves, or may have a notch portion or a protrusion portion for receiving a fixing jig or a handling jig at intermediate positions along the sides.

In addition, as shown in FIG. 2, which is a conceptual view illustrating an arrangement of the mask, the mask according to the present invention is arranged such that the normal to the surface on which the pattern is formed is oriented in a substantially horizontal direction in the second optical functional unit 20. Note that θ in FIG. 2 indicates the angle between the vertical and horizontal directions (θ=90°). In other words, the mask 21 is regarded to be arranged such that two opposing sides 21A and 21B among the four sides forming the outer edge of the mask 21 are in a substantially perpendicular direction to a surface 100A on which the laser irradiation apparatus 100 is installed. Alternatively, in the second optical functional unit 20, the mask 21 may also be regarded to be arranged such that the normal to the surface on which the pattern is formed in the second optical functional unit faces an in-plane direction of the surface 100A. In this description, such an arrangement may also be simply referred to as arranging "vertically."

As described above, a larger irradiation size for the body to be irradiated has been required; accordingly, the mask has become larger. Furthermore, when a reduced projection optical system is employed, the mask size becomes even larger. Meanwhile, a degree of fineness of the irradiation treatment to the body to be irradiated, such as a substrate, is increasing, and thus, any distortion in an image of the mask affects accuracy of the irradiation treatment.

When the mask is installed in a same horizontal direction as the surface on which the apparatus is installed, as in Patent Document 2, installation of the mask alone may be distorted due to gravity, thereby deteriorating the accuracy of the irradiation treatment.

When a support is inserted below the mask to suppress the generation of deflection, the support is required to be optically transparent. However, when the mask becomes larger, a support material is required to be thickened, which not only leads to a problem in cost but also results in increased absorption of laser energy in this support material, thereby reducing energy efficiency of the laser irradiation.

In addition, when the mask is installed parallel to the surface on which the apparatus is installed, a risk of particles falling onto the mask increases, and when production is made with the particles on the mask remaining, quality failure in a large number of products occurs.

Moreover, in a case where particles enter between the support material below the mask and the mask, not only product defect and the mask damaged due to the effect of the particles, but also optical inhomogeneity is generated because the slight gap partially generated between the support material and the mask has a different refractive index. As a result, a non-uniform laser beam is irradiated.

Moreover, because the optical path length from the laser source to the substrate is long, the height of the apparatus increases when placing the mask horizontally. By erecting the mask, the height of the apparatus can be reduced.

As in the laser irradiation treatment apparatus according to the present invention, when the mask 21 is arranged such that the normal to the surface on which the pattern is formed is oriented in a substantially horizontal direction, the deflection of the mask 21 is suppressed. Consequently, the support to prevent the deflection by an optically transparent member is unnecessary; it is possible to perform the highly accurate and extremely uniform irradiation treatment with highly efficient use of the laser energy. In addition, the laser irradiation apparatus can be configured such that the adhesion of the particles on the mask surface can be suppressed, which reduces the defect caused by the particles. Furthermore, since it is possible to align the large part of the long optical path with a horizontal plane, the height of the apparatus can be reduced. This can realize a pellicle-less configuration.

Note that the surface 100A, on which the laser irradiation apparatus 100 is installed, can be defined as a horizontal plane. Moreover, the mask 21 is arranged such that the normal to the surface on which the pattern is formed is oriented in a substantially horizontal direction. This orientation is intended by design and indicates that the mask is arranged to orient the normal in a horizontal direction. Additionally, this includes a range of deviations from the horizontal direction within production and installation tolerances. It is therefore most preferable that the mask is arranged such that the normal to the surface on which the pattern is formed is oriented in a horizontal direction, in other words, the mask is arranged perpendicular (θ=90° in FIG. 2) to the horizontal surface on which the laser irradiation apparatus 100 is installed.

In addition, such a laser irradiation system described above can be provided.

Hereinafter, a further detailed description will be given.

### (First Optical Functional Unit)

The first optical functional unit 10 is provided with the laser source 11. The laser source 11 may be, for example, a laser source (laser oscillator) that irradiates (emits) a laser beam 1 in a form of pulses.

The laser beam 1 irradiated from the laser source 11 is preferably generated by an excimer laser. The excimer laser has a shorter wavelength than a conventional solid-state laser, such as an LD pumped solid-state (DPSS) laser, resulting in higher resolution. Consequently, in a laser irradiation treatment apparatus 200, the use of the excimer laser enables a finer laser irradiation treatment processing. Furthermore, for example, epoxy-based substrate materials have extremely high absorbance for the excimer laser, and the excimer laser has high laser irradiation treatment capability for these materials.

Furthermore, a shaping optical system 12 configured to be irradiated with the laser beam 1 from the laser source 11 may be provided. The shaping optical system 12 may shape an irradiation shape of the laser beam 1, such as that shown in FIG. 1(a), into a rectangular irradiation shape, for example, shown in FIG. 1(b). For example, it is preferable that the shaping optical system 12 is an optical system that includes a plurality of cylindrical lenses, and forms the laser beam 1 from the laser source 11 into a laser beam having an irradiation shape that is a rectangular shape with uniform irradiation energy density, in particular, into a top-hat type laser beam.

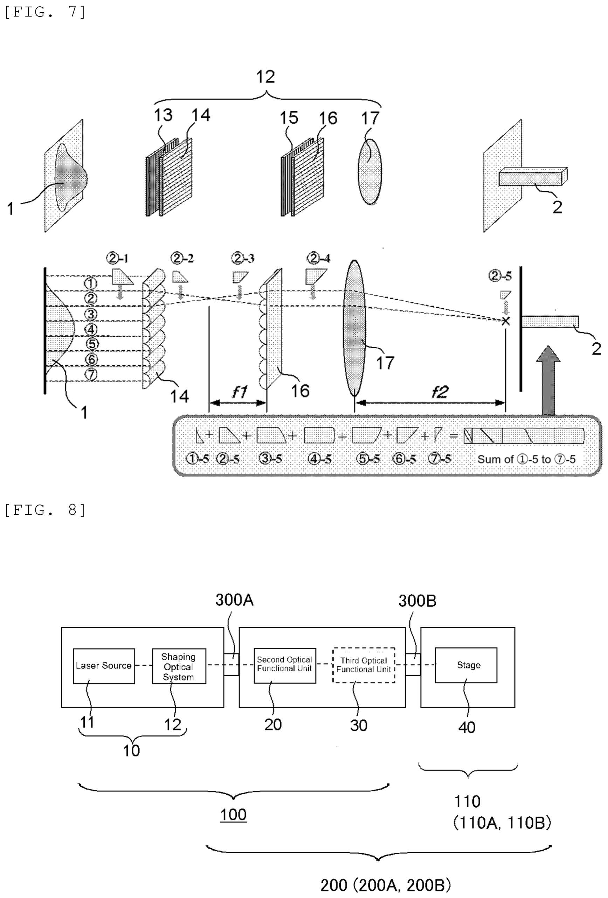

FIG. 7 is a conceptual view of shaping a laser beam irradiation shape in a shaping optical system provided with a plurality of cylindrical lenses. The shaping optical system 12 shown in FIG. 7 is provided with a plurality of cylindrical lenses, including an X1 cylindrical lens 13, a Y1 cylindrical lens 14, an X2 cylindrical lens 15, and a Y2 cylindrical lens 16, and with a condenser lens 17. The X1 cylindrical lens 13 and the X2 cylindrical lens 15 are arranged with a spacing twice a focal distance f1 thereof, as shown in a lower part of FIG. 7. The Y1 cylindrical lens 14 and the Y2 cylindrical lens 16 are also arranged with a spacing twice the focal distance thereof.

The laser beam 1 oscillated by the laser source 11 shown in FIG. 1 has a non-uniform irradiation shape (beam profile) as shown in FIG. 7. When the laser beam 1 having such an irradiation shape enters the shaping optical system 12, each component of the laser beam 1 is shaped according to positions in an X direction and a Y direction thereof. The lower part of FIG. 7 schematically shows, for example, an image in which the component indicated by "2" is shaped through the cylindrical lenses 14 and 16. Each component of the laser beam 1 is shaped by the cylindrical lenses 13 to 16, and condensed at a position spaced from the condenser lens 17 by a focal distance f2. By condensing the light of each component, the laser beam 2, which has the top-hat beam shape as shown in FIG. 7, is emitted from the shaping optical system 12 as emitting light.

By rearranging the configuration of the cylindrical lenses in the X direction and the Y direction, it is possible to shape the beam shapes into a square, a rectangle, or the like.

By shaping the irradiation shape of the laser beam 1 using such a plurality of cylindrical lenses 13 to 16, it is possible to shape the high-quality laser beam 2 having a rectangular shape with extremely uniform energy density, in particular, the top-hat type beam profile.

Moreover, by performing superimposed irradiation using such a rectangular beam profile, a dead spot that is an unirradiated region is eliminated, and an averaged laser irradiation treatment can be performed within an acceptable range of a desired laser irradiation treatment, enabling an extremely accurate and efficient laser irradiation treatment on the body 80 to be irradiated.

### (Second Optical Functional Unit)

As described above, the second optical functional unit 20 is provided with the mask. The present invention is effective when the mask has a thin thickness. Accordingly, it is preferable that the mask 21 has a thickness of 10 mm or less at the effective area 22 in the laser transmission direction. In one embodiment, in which the length of the longest side is 800 mm or more, this thickness is more preferably 8 mm or less. The lower limit thereof is not particularly limited, but can be 2 mm. The thickness of those commonly used is approximately 5 mm from the viewpoint of ease of handling. Alternatively, in another embodiment, in which the length of the shortest side is 1000 mm or more, this thickness is more preferably 8 mm or less, and further preferably 6 mm or less. The lower limit thereof is not particularly limited, but from a viewpoint of ease of handling, approximately 5 mm. Note that, depending on the size of the mask, the upper limit of the thickness may be set to approximately 20 mm or 15 mm. When the mask has a thin thickness in this way, the handling thereof is easy and low in cost. In the laser irradiation apparatus according to the present invention, even in a case of such a thin mask, problems such as deflection due to the self-weight of the mask can be stably suppressed.

Note that in one embodiment of the present invention, the size of the mask 21 is not particularly limited as long as the mask is a quadrilateral having the outer edge of the mask formed by four sides, a longest side of which has a length of 800 mm or more. In the present invention, for example, it is possible to use the mask 21 in which the longer of either horizontal and vertical dimensions perpendicular to a thickness direction (dimensions L1 and L2 in FIG. 3, respectively) are 800 mm or more, more preferably 1000 mm or more, as well as horizontal and vertical dimensions perpendicular to a thickness direction of the effective area 22 (dimensions L3 and L4 in FIG. 3, respectively) are 500 mm or more, more preferably 700 mm or more. The upper limits of the dimensions L1 and L2 are not particularly limited; for example, the upper limits can be 2500 mm or may be 2000 mm. In addition, the upper limits of the dimensions L3 and L4 are not particularly limited; for example, the upper limits can be 2350 mm or may be 1850 mm. Note that the present invention is more effective when the size of the mask is larger, and such dimensions L1 and L2 are 1500 mm or more; those of 1700 mm or more are more effective. These dimensional conditions may be satisfied by both L1 and L2, or by either one of them.

Alternatively, in another embodiment of the present invention, the size of the mask 21 is not particularly limited as long as the mask is a quadrilateral having the outer edge of the mask formed by four sides, a shortest side of which has a length of 1000 mm or more. In the present invention, for example, it is possible to use the mask 21 in which the shorter of the horizontal and vertical dimensions perpendicular to a thickness direction (dimensions L1 and L2 in FIG. 3, respectively) are 1000 mm or more, more preferably 1100 mm or more, as well as horizontal and vertical dimensions perpendicular to a thickness direction of the effective area 22 (dimensions L3 and L4 in FIG. 3, respectively) are 700 mm or more, more preferably 900 mm or more. The upper limits of the dimensions L1 and L2 are not particularly limited; for example, the upper limits can be 2500 mm or may be 2000 mm. In addition, the upper limits of the dimensions L3 and L4 are not particularly limited; for example, the upper limits can be 2350 mm or may be 1850 mm. Note that the present invention is more effective when the size of the mask is larger, and such dimensions L1 and L2 are 1500 mm or more; those of 1700 mm or more are more effective. These dimensional conditions may be satisfied by both L1 and L2, or by either one of them.

Moreover, a ratio of the horizontal dimension to the vertical dimension perpendicular to the thickness direction of the mask (L1/L2, L3/L4) can be 1/2 or more and 2/1 or less, more preferably 4/5 or more and 5/4 or less.

The weight of the mask is not particularly limited. For example, the weight can be 5 kg or more and 70 kg or less, more preferably 5 kg or more and 20 kg or less, and further preferably 5 kg or more and 15 kg or less.

These masks are formed, for example, by forming a light-shielding thin film, made of materials such as chromium, on a transparent substrate that transmits a laser light, and then by forming a pattern on this light-shielding thin film to form an opening. The transparent substrate is preferably formed with a glass material; examples include a synthetic fused silica substrate, a fused silica substrate, an aluminosilicate glass substrate, a soda-lime glass substrate, a low thermal expansion glass substrate (SiO₂-TiO₂ glass, etc.), and the like. The synthetic fused silica is suitable among these from a viewpoint of transmittance, rigidity, and ease of availability.

In the present invention, such a large mask 21 can be used. In addition, by using the large mask 21 and a reduced projection optical system 31 together, the energy density of the laser beam irradiated onto the substrate can be increased. As a more specific example, a mask having an outer dimension of 800 mm × 920 mm and the effective area 22 having a size of 500 mm × 500 mm can be exemplified as an example of one embodiment. Alternatively, as an example of another embodiment, a mask having an outer dimension of 1000 mm × 1150 mm and the effective area 22 having a size of 700 mm × 700 mm can be exemplified.

The mask 21 may include a mask irradiation area that is irradiated with the laser beam 2, which has passed through the first optical functional unit 10. In this case, the mask irradiation area is a portion of the effective area 22 of the mask 21.

It is preferable that the second optical functional unit 20 further includes a mask stage that holds the mask 21 and moves the mask 21 with sweeping. By attaching a sweep shaft to the mask stage on which the mask 21 is held, the sweep operation of the mask can be performed efficiently.

Furthermore, by adding a correction function (tilt axis, θ axis) to the mask stage, the installation angle (perpendicular) of the mask is readily adjusted, and the correction can be readily performed to the surface shape of the body 80 to be irradiated, which is to be irradiated, enabling accurate irradiation.

The second optical functional unit 20 can be configured to further shape the irradiation shape of the laser beam 2 through the mask 21, in which the laser beam 2 has passed through the first optical functional unit 10. The second optical functional unit 20 can further shape the irradiation shape of the laser beam 2, shaped into a rectangular shape according to, for example, a pattern corresponding to a region 81 to be irradiated of the body 80 to be irradiated.

In the laser irradiation apparatus 100 according to the present invention, a laser beam 3 that has passed through the second optical functional unit 20 and has the irradiation shape shown in, for example, FIG. 1(c) may be configured to be redirected as shown in FIG. 1(d) by any reflecting mirror 50 to enter any third optical functional unit 30 (described later). In an example of the laser irradiation apparatus 100 shown in FIG. 1, a laser beam 3 emitted from the third optical functional unit 30 is configured to be irradiated to a portion of the body 80 to be irradiated held on a stage 40.

### (Third Optical Functional Unit)

In the laser irradiation apparatus 100 according to the present invention, as shown in FIG. 1, it is preferable that the third optical functional unit 30 provided with the reduced projection optical system 31 is further included between the second optical functional unit 20 and the stage 40 that holds the body to be irradiated. The irradiation area of the laser beam 3 that has passed through the mask 21 can be reduced through any reduced optical system 31 described later to increase energy density of the laser beam 4 to be irradiated to the substrate. Consequently, even when the large-area mask 21 is enlarged, an intended fine irradiation treatment can be performed by the combined use of the enlarged mask 21 with the corresponding reduced optical system 31.

In recent years, a finer resolution of the laser irradiation treatment, such as substrate processing or exposure, has advanced, and a minimum width of the laser irradiation is required to be several µm. This results in adverse effects from fine particles, in particular, the fine particles adhering to the mask portion, generating a large number of failures. Consequently, by enlarging the mask 21 beyond an actual irradiation size and then subjecting the laser beam 3 that has passed through the mask 21 to reduced projection optical exposure through the following reduced projection optical system 31, the effect caused by fine particles can be minimized. Thereby, the pellicle-less configuration can be more readily realized.

In addition, by enlarging the mask 21 beyond the actual laser irradiation pattern, the energy of the laser beam 2 that comes into contact with the mask 21 can be reduced compared to the laser irradiation treatment energy. When a reduction ratio of the reduced projection optical system 31 is defined as N, the energy of the laser beam incident on the mask surface is 1/(N²), compared to the laser irradiation energy incident on the surface of the body 80 to be irradiated. Accordingly, thermal drift due to the energy of the laser beam 2 can be suppressed, thereby enabling suppression of thermal expansion of the mask 21 and enabling highly accurate laser irradiation treatment even after prolonged laser irradiation operation.

Furthermore, the degradation of an optical member (for example, the shaping optical system 12 and the mask 21) due to heat from the laser beam can be suppressed, and it is possible to extend lifetime of the optical member.

Furthermore, in the laser irradiation apparatus 100 configured to perform a synchronized sweeping irradiation under the conditions in which the irradiation position of the laser beam is fixed as described above, a reduced projection lens having a very small aperture can be used compared to, for example, the method disclosed in Patent Document 2, in which the irradiation position of the laser beam is moved. Therefore, in addition to being economically advantageous, the lens exhibits small distortion, and lens-induced aberration can be minimized, thereby enabling the laser irradiation accuracy to be extremely improved.

The reduced projection optical system 31 can be provided with a pair of reduced projection lenses. In a case where the reduced projection optical system 31 is an infinity optical system, the magnification by the reduced projection optical system 31 can be adjusted, for example, by the ratio of the focal distances of the reduced projection lenses and the distance between the reduced projection lenses. Note that this reduction ratio N can be, for example, 2 or more, preferably 3 or more, more preferably 4 or more. The upper limit thereof is not particularly limited, but it is approximately 5 from a viewpoint of the laser resistance of the mask and the laser energy density required for processing a required workpiece.

It is preferable that the reduced projection lens has a high NA (numerical aperture). By using a reduced projection lens having a high NA, it is possible to form the VIA and the trench having a shape closer to a cylindrical shape.

It is preferable that the NA of the reduced projection lens is selected according to the energy density required for the laser irradiation treatment on the body 80 to be irradiated. It is preferable that the NA of the reduced projection lens is 0.12 or more.

It is preferable that the third optical functional unit 30 is further provided with a cooling means for cooling the reduced projection optical system 31. By providing the cooling means, it is possible to further suppress the effect of heat from the laser beam energy in the reduced projection optical system 30. In the reduced projection optical system 30, since the laser beam 3 that has passed through the mask 21 is subjected to reduced projection of 1/N, the energy of the laser beam passing through the lens portion of an objective tip side is N² times larger than energy of the laser beam irradiated to the mask 21, and this portion is more likely to be affected by the heat. Therefore, by providing a cooling function to the reduced projection optical system 30 in order to suppress this thermal energy, thermal drift due to the energy of the laser beam can be suppressed, which enables highly accurate laser irradiation even after long-time laser irradiation operation.

In addition, in the above-described laser irradiation apparatus 100 configured to perform synchronous sweep irradiation with the irradiation position of the laser beam being fixed, it is possible to use a reduced projection lens having an extremely small aperture compared with the method of Patent Document 2. Regarding the cooling means for the reduced projection lens, the cooling means cannot be directly provided to the lens itself, but cooling is provided to a jacket portion that holds the lens. Therefore, as the lens aperture becomes larger, the temperature can be managed in the area surrounding the lens, but near the central portion, which is the critical portion, the cooling effect is difficult to spread, and the heat is difficult to manage. Therefore, even slight energy absorption into the lens due to the long-time laser beam irradiation easily causes distortion due to the heat. With the third optical functional unit 30 having the cooling function and the lens with the small aperture being used, such a problem can be suppressed. Moreover, the failures caused by the laser beam irradiation to the reduced projection optical system 31 can be suppressed, and thereby the lifetime thereof can be extended.

### [Laser Irradiation Treatment Apparatus]

FIG. 8 shows a configuration of the laser irradiation treatment apparatus 200 according to the present invention. The laser irradiation treatment apparatus 200 according to the present invention is provided with the laser irradiation apparatus 100 described above and a laser irradiation treatment unit 110, which includes the stage 40 for mounting the body to be irradiated, such as a substrate.

### [Sweep Mechanism]

It is also preferable that the laser irradiation treatment apparatus 200 is configured to make the mask 21 and the substrate stage 40 move nonstop with sweeping in at least one direction during sweep irradiation, while respectively irradiating the mask 21 and the substrate stage 40 with the laser beams 2 and 4 in a pulsed manner.

By performing the nonstop sweep irradiation, the time of sweep can be significantly reduced compared with step-and-repeat operation, in which traveling and stopping are repeated. In particular, since the positioning required in entering the stopping state from the traveling state is eliminated, it is possible to prevent deterioration of positional accuracy due to the acceleration and deceleration.

Furthermore, since such an operation occurs frequently, a load on a traveling shaft and a motor becomes large when traveling and stopping are repeated. By performing the sweep irradiation operation without stopping, the load on the shaft can be reduced and heat generation at the traveling shaft portion can be suppressed, which enables further prevention of deterioration of the positional accuracy due to thermal drift and enables an extremely highly accurate laser irradiation treatment.

### [Imaging Means and Alignment Mechanism]

It is preferable that the laser irradiation treatment apparatus 200 of the present invention further includes an imaging means for reading a feature portion of the body 80 to be irradiated, an imaging means for reading a feature portion of the mask 21, and an alignment mechanism that aligns relative positions of the body to be irradiated and the mask based on positional information on the feature portion of the body to be irradiated and the feature portion of the mask.

The laser irradiation treatment apparatus 200 shown in FIG. 1 includes an alignment camera 23 for the mask as the imaging means for reading the feature portion of the mask 21, an alignment camera 60 for the body to be irradiated as the imaging means for reading the feature portion of the body 80 to be irradiated, and the alignment mechanism not shown. The alignment camera 23 for the mask is configured to send positional information on the feature portion of the mask 21 to the alignment mechanism. The alignment camera 60 for the body to be irradiated is configured to send positional information on the feature portion of the body 80 to be irradiated to the alignment mechanism. The alignment mechanism is configured to align the relative position of the body 80 to be irradiated and the mask 21 based on these pieces of positional information.

By aligning the position of the mask 21 with the position of the body 80 to be irradiated using the imaging means, it is possible to perform the laser irradiation treatment in which the mask pattern is projected onto an accurate position of the surface of the body 80 to be irradiated.

In particular, when the body to be irradiated is processed, the body to be irradiated is often laser-irradiated over a plurality of layers, and when the position of the laser irradiation treatment of each layer is not accurately aligned with the intended position, quality failures occur, for example, circuits on each layer are not connected, or even when the connection is established, conduction resistance is high. In order to suppress these failures, the accuracy of the position of the laser irradiation treatment is required.

In this case, it is preferable that a means for correcting a laser irradiation shape on the body 80 to be irradiated with respect to the pattern of the mask 21, based on information of the alignment mechanism, is further included.

The shape of the projected image of the pattern of the mask 21 is not always exactly the same shape with respect to the laser irradiating shape on the body 80 to be irradiated, and the magnification is not always the same due to the effect of thermal expansion or the like. Furthermore, in some cases, due to minute distortion or deformation of the body 80 to be irradiated, the laser irradiation shape on the body 80 to be irradiated is required to be deformed to the projected image of the mask 21.

Consequently, as described above, the position of the mask 21 and the position of the body 80 to be irradiated are acquired by the imaging means (the alignment camera 23 for the mask and the alignment camera 60 for the body to be irradiated), and, based on information therefrom, the projected image of the mask 21 is aligned with the shape on the body to be irradiated, which is to be subjected to the laser irradiation treatment, thereby enabling the accurate laser irradiation treatment on the body to be irradiated.

Specifically, for example, the projection position of the projected image of the mask 21 is acquired by a beam image detection camera 70 and corrected based on the information on this projection position to optimize the projection magnification by the third optical function unit 30, and the sweep speed during sweep irradiation is optimized based on the above-described information. As a result, a longitudinal magnification and a lateral magnification of the image on the body 80 to be irradiated with respect to the image of the mask 21 can be adjusted as required within a certain degree of range, and the optimal shape of the laser irradiation treatment can be applied.

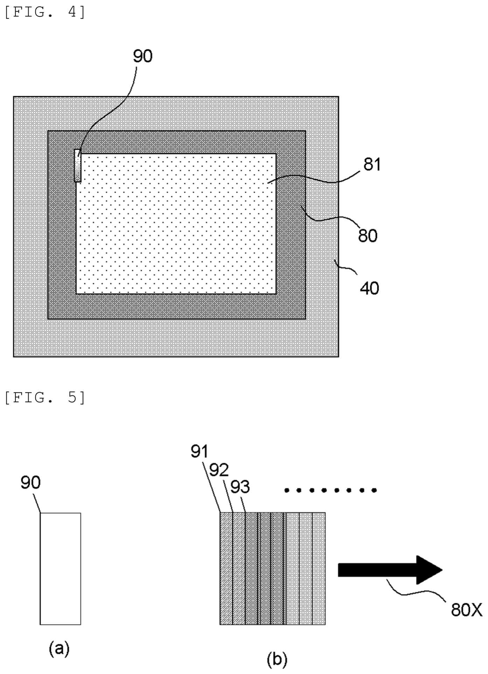

The body 80 to be irradiated may include an irradiation area onto which the pattern is projected by any of the laser beams 2 to 4 that have passed through the mask 21 (and optional third optical functional unit 30). FIG. 4 shows a state in which the body 80 to be irradiated is mounted on the stage 40, showing an example of a relation between an irradiation area 90 of the body 80 to be irradiated, where the laser beam 3 is irradiated, and the region 81 to be irradiated of the body 80 to be irradiated. As shown in FIG. 4, the irradiation area 90 is smaller than the region 81 to be irradiated of the body 80 to be irradiated.

The irradiation area 90 shown in FIG. 4 is an irradiation area formed by a single shot of the pulsed laser beam 4. Moreover, the pattern is projected by the laser beam passed through the mask 21, resulting in the irradiation area 90 corresponding to the mask irradiation area, which is a portion of the effective area 22 of the mask 21.

As shown in the example of FIG. 1, the mask 21 is configured to be scanned (swept) along sweep axes 21X and 21Y shown in FIG. 1. In addition, the stage 40 is configured to be scanned along sweep axes 80X and 80Y shown in FIG. 1.

Furthermore, the laser irradiation treatment apparatus 200 of the present invention is configured to perform sweep irradiation of the mask 21 and the stage 40 with the laser beams 2 and 4 to subject the region 81 to be irradiated of the body 80 to be irradiated to the laser irradiation treatment.

### [Mask Changer]

The laser irradiation treatment apparatus 200 according to the present invention is preferably provided with a mask changer, and the installation of the mask is preferably performed using the mask changer. For example, a vertical mask changer configured to exchange a plurality of masks can be further provided. The processing apparatus provided with such a vertical mask changer can be a laser irradiation treatment apparatus capable of readily forming various patterns.

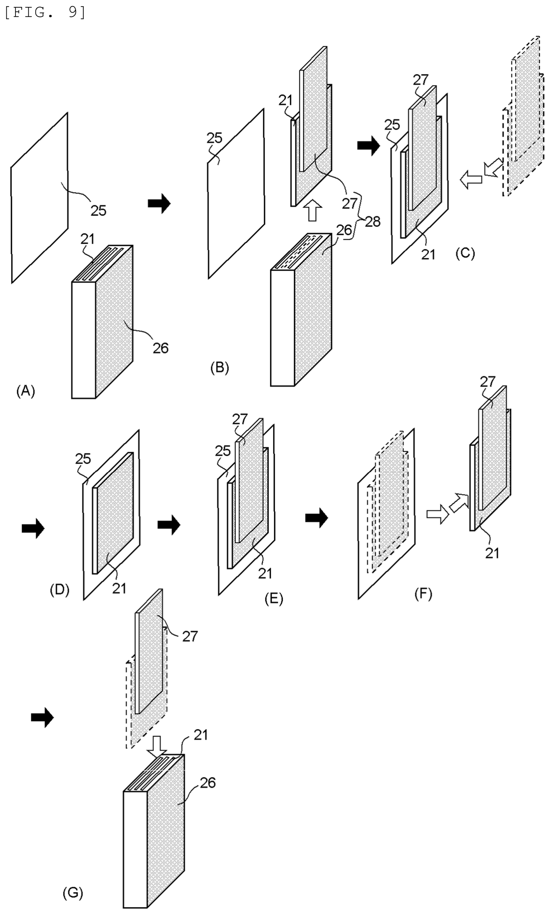

FIG. 9 shows a schematic view of an example of the vertical mask changer and an example of mask exchange using it. In this example, FIG. 9(A) shows an example of installing and exchanging the mask 21 installed on a mask holder 25 shown schematically. Moreover, in this example, a mask stocker 26 is used as a part of the vertical mask changer. The mask stocker 26 is configured to accommodate a plurality of masks.

First, as shown in FIG. 9(B), the mask 21 is taken out from the mask stocker 26 using a mask clamp 27. The mode in which the mask 21 is gripped (clamped ) by the mask clamp 27 is not particularly limited. The mask stocker 26 and the mask clamp 27 configure a vertical mask changer 28, which is configured to exchange a plurality of masks 21.

As shown in FIG. 9(C), the mask 21 is installed on the mask holder 25 while maintaining vertical orientation. After installation, as shown in FIG. 9(D), the grip by the mask clamp 27 is released (unclamped).

During the exchange, as shown in FIG. 9(E), the mask 21 installed on the mask holder 25 is gripped by the mask clamp 27. Subsequently, as shown in FIG. 9(F), the mask 21 is released from the mask holder 25. The mask 21 released is stored in the mask stocker 26, as shown in FIG. 9(G). Subsequently, a mask 21, which is desired to be used next, is taken out from the mask stocker 26 in the same way as shown in FIG. 9(B). Then, this mask 21 is installed on the mask holder 25 following the procedure previously described. This enables a plurality of masks 21 to be exchanged while maintaining the vertical arrangement thereof. In this way, the laser irradiation apparatus can be configured such that various patterns can be easily formed. Furthermore, by exchanging the mask 21 while maintaining the vertical arrangement, it is possible to prevent an accumulation of foreign matter, such as dust, on the effective area of the mask 21 during the exchange of the mask 21, and the deflection, or the like, of the mask 21.

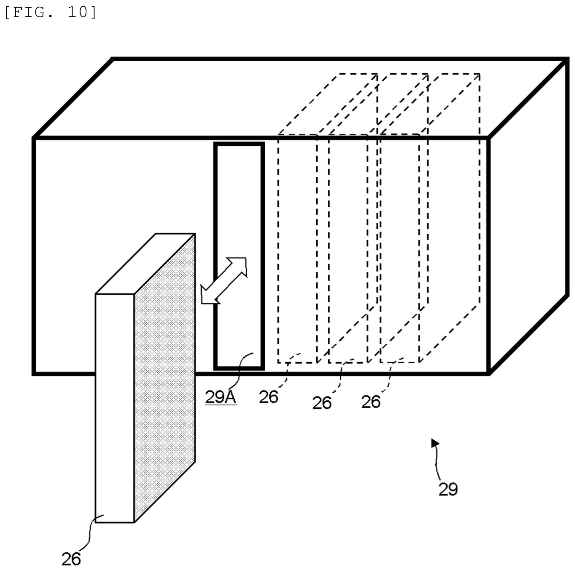

The laser irradiation treatment apparatus 200 according to the present invention can also be provided with a mask cabinet 29 shown in FIG. 10. The mask cabinet 29 is configured to load and unload a plurality of the mask stockers 26. For example, the mask cabinet 29 includes an opening 29A, and is configured such that the mask stocker 26, with the desired mask 21 being loaded within, can be moved to a position of the opening 29A in the mask cabinet 29 while maintaining the mask 21 in the vertical arrangement.

### [Method for Installing Mask]

Next, the method for installing a mask according to the present invention will be described. The method for installing a mask according to the present invention is a method to install the mask 21 in the laser irradiation apparatus 100 for irradiating the body 80 to be irradiated with a laser through the mask 21 installed in the second optical functional unit 20. This laser irradiation apparatus 100 includes the first optical functional unit 10, including the laser source 11, and the second optical functional unit 20 for installing the mask 21 having the pattern corresponding to the laser-irradiated region of the body 80 to be irradiated.

In one embodiment of the method for installing a mask according to the present invention, a quadrilateral mask having an outer edge formed by four sides, in which the longest side has a length of 800 mm or more, is used as the mask 21. The mask 21 is installed in the second optical functional unit 20 such that the normal to the surface on which the pattern is formed is oriented in a substantially horizontal direction. It is also preferable that a quadrilateral mask, in which, among the four sides forming the outer edge of the mask, the ratio of the length of the longest side to the thickness of the effective area 22 in the laser transmission direction (length / thickness) is 100 or more, is used as the mask 21.

In another embodiment of the method for installing a mask according to the present invention, a quadrilateral mask having an outer edge formed by four sides, in which the shortest side has a length of 1000 mm or more, is used as the mask 21. The mask 21 is installed in the second optical functional unit 20 such that the normal to the surface on which the pattern is formed is oriented in a substantially horizontal direction. It is also preferable that a quadrilateral mask, in which, among the four sides forming the outer edge of the mask, the ratio of the length of the shortest side to the thickness of the effective area 22 in the laser transmission direction (length / thickness) is 100 or more, is used as the mask 21.

According to such a method for installing a mask, the highly accurate laser irradiation can be performed while suppressing the effect of deflection due to the self-weight of the mask. In addition, the laser irradiation apparatus can be configured such that the adhesion of the particles on the mask surface can be suppressed, which reduces the defect caused by the particles. Furthermore, since it is possible to align the large part of the long optical path with the horizontal plane, the height of the apparatus can be reduced.

As described above, a mask having a thickness of 10 mm or less in the laser transmission direction at the effective area 22 can be used as the mask 21. Consequently, the laser irradiation apparatus can be configured such that the problems, such as the deflection due to the self-weight of the mask, are stably suppressed, while being easy to handle and low in cost due to the thinness of the mask.

### [Laser Processing Apparatus]

As shown in FIG. 8, a laser processing apparatus 200A can be provided as the laser irradiation treatment apparatus 200 by combining the laser irradiation apparatus 100 according to the present invention and a laser irradiation processing unit 110A, which is the laser irradiation treatment unit 110, provided with the stage 40 that holds the body 80 to be irradiated. The laser processing apparatus 200A forms minute recesses and protrusions by ablation processing using the irradiation energy of the laser beam 4 to the body 80 to be irradiated. The laser processing apparatus according to the present invention is configured such that problems, such as deflection of the mask due to the self-weight of the mask and adhesion of particles to the mask, are suppressed.

In the laser processing apparatus 200A according to the present invention, it is preferable that the second optical functional unit 20, the first optical function 10, and the laser irradiation processing unit 110A are separable from each other. This facilitates separated transportation and enables a reduction in installation cost. For example, as shown in FIG. 8, the laser processing apparatus 200A can be made separable by providing, e.g., a detachable unit 300A between the second optical functional unit 20 and the first optical function 10, and a detachable unit 300B between the second optical functional unit 20 and the laser irradiation processing unit 110A.

It is preferable to further provide the mask changer 28 capable of installing and removing the mask 21 to and from the second optical functional unit 20. This enables the laser processing apparatus to easily process various patterns. Regarding the mask changer 28, refer to the above description.

Furthermore, a specific example of the laser processing using the inventive laser processing apparatus 200A provided with the inventive laser irradiation apparatus 100 will be described below in detail. The inventive laser processing apparatus 200A may be configured to perform the superimposed irradiation (first aspect), and/or to perform synchronous sweep irradiation while keeping an irradiation position of the laser beam fixed (second aspect).

### (First Aspect)

During the irradiation treatment operation on the body 80 to be irradiated, the laser processing apparatus 200A in the first aspect is configured to perform the laser irradiation treatment on the region 81 to be irradiated of the body 80 to be irradiated by sweep irradiation of the mask 21 and the stage 40 while superimposing a portion of the irradiation area 90. Hereinafter, the irradiation with the laser beam while superimposing a portion of the irradiation area 90 is referred to as superimposed irradiation.

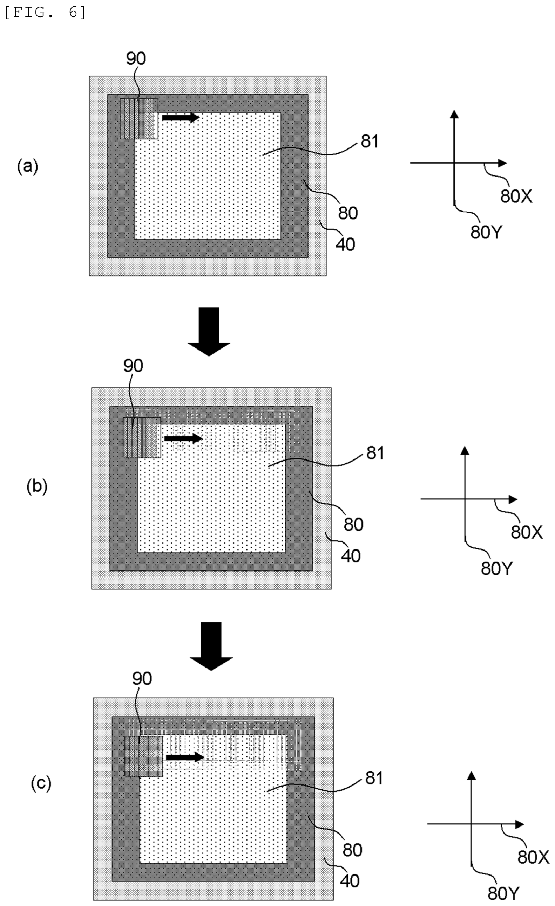

Next, an example of the superimposed irradiation will be described with reference to FIGs. 5 and 6.

FIG. 5(a) shows the irradiation area 90 on the body 80 to be irradiated with a pulsed one-shot of the laser beam. In the superimposed irradiation of this example, the mask 21 and the stage 40 are swept and irradiated with the laser beam such that, as shown in FIG. 5(b), an irradiation area 91 subjected to the first shot is partially superimposed on an irradiation area 92 subjected to the second shot in a direction of an arrow along the sweep axis 80X. Subsequently, the laser beam is irradiated such that an irradiation area 93 subjected to the third shot is partially superimposed on the irradiation area 91 subjected to the first shot and the irradiation area 92 subjected to the second shot. By repeating such superimposed irradiation from the fourth shot onward, the processed region is expanded along the sweep axis 80X.

FIG. 6(a) shows a step of performing the ablation processing on a first row of the region 81 to be irradiated along the sweep axis 80X by the superimposed irradiation shown in FIG. 5(b). Next, as shown in FIG. 6(b), the superimposed irradiation is performed along the sweep axis 80X so as to superimpose on a portion of the regions that have been subjected to the superimposed irradiation in FIG. 6(a) in a direction of a sweep axis 80Y (orthogonal to the sweep axis 80X) to perform the ablation processing on a second row of the region 81 to be irradiated along the sweep axis 80X. Then, as shown in FIG. 6(c), the superimposed irradiation is performed along the sweep axis 80X so as to superimpose on a portion of the region that has been subjected to the superimposed irradiation in FIGs. 6(a) and (b) in the direction of the sweep axis 80Y to perform the ablation processing on a third row of the region 81 to be irradiated along the sweep axis 80X. By repeating such superimposed irradiation on the fourth row of the region 81 to be irradiated onward, the processed area is expanded across the region 81 to be irradiated. As a result, the superimposed irradiation can be performed at a regular interval in each of the two directions of the sweep axis 80X and 80Y.

The superimposed portions of the irradiation area undergo a plurality of laser beam irradiations. As a result, the portions undergo deep ablation processing according to the pattern shape of the mask, and it is possible to achieve processing with a desired depth according to the pattern shape of the mask required for the region 81 to be irradiated.

In such a laser processing apparatus 200A in the first aspect, the pulsed rectangular laser beam having uniform irradiation energy density is converted through the mask 21 into the laser beam 4 having a processing shape, and the irradiation area 90 of the body 80 to be irradiated is irradiated with the laser beam 4. Accordingly, a plurality of irradiations can be performed with a uniform processing depth of the irradiation area 90 in the body 80 to be irradiated corresponding to the mask irradiation area that is a portion of the effective area 22 of the mask 21, and a nearly uniform recesses and protrusions processing can be accurately performed across the region 81 to be irradiated of the body 80 to be irradiated. Therefore, according to this laser processing apparatus 200A, it is possible to accurately perform the fine recesses and protrusions processing across the region 81 to be irradiated of the body 80 to be irradiated.

Furthermore, such a laser processing apparatus 200A does not require the use of high laser energy and can be configured inexpensively without the use of an expensive laser source or optical member. This apparatus 200A also suppresses the accuracy deterioration due to thermal drift of the laser beam, and enables highly accurate processing.

In addition, the laser processing apparatus 200A can irradiate the body to be irradiated with the laser beam 4 in pulses, and thus, can perform the above-described superimposed irradiation at high speed.

That is, according to the laser processing apparatus 200A in the first aspect of the present invention, it is possible to perform a deep VIA forming process and/or trench forming process at high speed.

Furthermore, according to the laser processing apparatus 200A in the first aspect of the present invention, the superimposed irradiation is performed, and thus, the substrate irradiation area for one shot can be made small. As a result, high-density irradiation becomes possible.

### (Second Aspect)

In the laser processing apparatus 200A in the second aspect, the mask 21 and the stage 40 are configured to operate in synchronization in a plane direction that is substantially vertical to a direction of irradiation of the laser beams 2 and 4, thereby maintaining a relatively corresponding positional relation therebetween.

In the example of FIG. 1, the mask 21 and the stage 40 are configured to synchronize the operation of the mask 21 along the sweep axis 21X with the operation of the stage 40 along the sweep axis 80X, in addition, to synchronize the operation of the mask 21 along the sweep axis 21Y with the operation of stage 40 along the sweep axis 80Y, thereby maintaining a relatively corresponding positional relation between the mask 21 and the stage 40.

Furthermore, the laser processing apparatus 200A in the second aspect is configured to, during processing operation on body 80 to be irradiated, cause the mask 21 and the stage 40 to operate in synchronization and subject the mask 21 and the stage 40 to sweep irradiation with an irradiation position of the laser beam 4 being fixed to perform a surface recesses and protrusions processing on the region 81 to be irradiated of the body 80 to be irradiated. Such a sweep irradiation that can be performed by the laser processing apparatus 200A in the second aspect is hereinafter referred to as "synchronous sweep irradiation with the irradiation position of the laser beam being fixed."

With such synchronous sweep irradiation, it is possible to perform laser irradiation treatment with higher accuracy than in the case of scanning with the laser beam. Furthermore, with such a laser processing apparatus 200A, a large-area mask can also be used as the mask 21, and the laser irradiation treatment can also be performed at a higher energy density by the combined use of the large-area mask with the third optical functional unit 30 described later.

Furthermore, in such a laser processing apparatus 200A in the second aspect, in the same way as in the laser processing apparatus 200A in the first aspect, the pulsed rectangular laser beam having uniform irradiation energy density is converted through the mask 21 into the laser beam 4 having a processing shape, and the irradiation area 90 of the body 80 to be irradiated is irradiated with the laser beam 4. Therefore, also in the laser processing apparatus 200A in the second aspect, in the same way as in the first aspect, a plurality of irradiations can be performed with a uniformed processing depth of the irradiation area 90 in the body 80 to be irradiated corresponding to the mask irradiation area that is a portion of the effective area 22 of the mask 21, and a nearly uniform recesses and protrusions processing can be accurately performed across the region 81 to be irradiated of the body 80 to be irradiated. Therefore, according to this laser processing apparatus 200A, it is also possible to accurately perform fine recesses and protrusions processing across the region 81 to be irradiated of the body 80 to be irradiated.

Moreover, such a laser processing apparatus 200A does not require the use of high laser energy and can be configured inexpensively without using an expensive laser source or optical member. In addition, this laser processing apparatus 200A can suppress the accuracy deterioration due to thermal drift of the laser beam, and can perform highly accurate processing. Moreover, since small components are usable for optical components, inexpensive and highly accurate optical components can be used.

Note that it is preferable that the laser processing apparatus 200A in the first aspect is configured to perform, in addition to the superimposed irradiation described earlier, synchronous sweep irradiation with the irradiation position of the laser beam being fixed, in the same way as in the second aspect.

### [Method for Laser Processing]

By using the laser processing apparatus 200A according to the present invention described above, the ablation processing on the surface of the body 80 to be irradiated can be performed. This enables the highly accurate processing while preventing the deformation of the mask and the adhesion of the particles to the mask.

The method for processing in the first aspect of the present invention is a method to perform the superimposed irradiation described earlier using the laser processing apparatus 200A in the first aspect described above. Consequently, with the method for processing in the first aspect according to the present invention, the fine recesses and protrusions processing can be performed across the region to be processed of the substrate. Moreover, it is possible to irradiate at high energy density and perform the deep VIA forming process and/or trench forming process at high speed.

The method for processing according to the present invention is not limited to the method using the laser processing apparatus 200A in the first aspect.

For example, a method for processing in the second aspect according to the present invention is a method in which the method forms minute recesses and protrusions on the surface of a substrate serving as the body 80 to be irradiated by the ablation processing using the irradiation energy of a laser beam. In this method, the laser beam is shaped into a rectangular shape and irradiated through the mask such that the substrate irradiation area is made smaller than the region to be processed on the substrate. During the processing operation on the substrate, the laser beam is irradiated onto the substrate while superimposing a portion of the substrate irradiation area, thereby performing the surface recesses and protrusions processing on the region to be processed of the substrate.

According to such a method for processing, the laser beam is irradiated onto the substrate such that the substrate irradiation area is smaller than the region to be processed of the substrate while superimposing a portion of the substrate irradiation area, thereby performing the surface recesses and protrusions processing on the region to be processed of the substrate. That is, by performing the superimposed irradiation, it is possible to accurately perform the nearly uniform recesses and protrusions processing across the region to be processed of the substrate. As a result, the fine recesses and protrusions processing can be performed with high accuracy across the region to be processed by employing the processing apparatus in this aspect.

Note that in the method for processing in the second aspect of the present invention, it is possible to perform a finer recesses and protrusions processing by using the excimer laser.

Alternatively, a method for processing in the third aspect of the present invention is a method for performing the above-described synchronous sweep irradiation with the irradiation position of the laser beam being fixed using the laser processing apparatus 200A in the second aspect described above. Consequently, with the method for processing in the third aspect of the present invention, the fine recesses and protrusions processing can be performed with high accuracy across the region to be processed of the substrate. Moreover, with the method for processing in the third aspect, it is possible to perform the processing with higher accuracy than that achieved by laser beam scanning. Moreover, with such a method for processing, a large-area mask can also be used as the mask 21, and the processing can also be performed at a higher energy density by the combined use of the large-area mask with the third optical functional unit 30 described earlier.

During the processing operation on the substrate, it is particularly preferable to simultaneously perform the superimposed irradiation described above and the above-described synchronous sweep irradiation with the irradiation position of the laser beam being fixed.

In the method for processing in the first aspect or the third aspect of the present invention, it is preferable to employ the laser processing apparatus 200A that satisfies one or more of the optional matters described earlier.

Moreover, in the method for processing in the first aspect or the third aspect of the present invention, it is preferable that, in the sweep irradiation in at least one direction, the mask 21 and the substrate stage 40 are moved nonstop with sweeping while the mask 21 and the substrate stage 40 are irradiated with the laser beam 2 or 4 in pulses, respectively.

By performing such a sweep, the time of sweep can be significantly reduced compared to the step-and-repeat operation in which traveling and stopping are repeated, based on the reason described earlier.

In the method for processing in the first aspect or the third aspect of the present invention, it is preferable that the sweep irradiation is repeatedly performed a plurality of times for each region 81 to be irradiated of the body 80 to be irradiated.

As described above, although finer processing of recesses and protrusions on the substrate is required, there is also a demand for high-aspect-ratio processing, which involves increasing the depth of these features.

However, the depth that can be processed by one sweep (1 pass) is limited, and especially in the above-described processing by the nonstop sweeping, irradiation cannot be performed at a plurality of times on one portion to be processed.

Accordingly, by performing the laser pulse irradiation while sweeping and repeating the irradiation a plurality of times for each region 81 to be irradiated of the body 80 to be irradiated, the processing can be achieved to the desired depth, and high-speed processing can be performed.

Note that, between the sweep operations (first sweep, second sweep, and onward), for example, as described with reference to FIGs. 4 and 5, the irradiation is performed while shifting the irradiation area 90 incrementally, thereby enabling averaging the processing depth to achieve uniform depth processing.

It is preferable that the method for processing in the first aspect or the third aspect further include reading the feature portion of the body 80 to be irradiated and the feature portion of the mask 21, and aligning, using the alignment mechanism, the relative position of the body 80 to be irradiated and the mask 21 based on the positional information on the feature portion of the body 80 to be irradiated and the feature portion of the mask 21.

The feature portion of the body 80 to be irradiated can be read, for example, by the alignment camera 60 for the substrate. The feature portion of the mask 21 can be read using, for example, the alignment camera 23 for the mask.

By aligning the position of the mask 21 with the position of the body 80 to be irradiated using the alignment mechanism based on the information obtained by the above-described alignment camera 23 for the mask and the alignment camera 60 for the substrate, it becomes possible to perform the recesses and protrusions processing in which the mask pattern is projected onto the accurate position on the surface of the body 80 to be irradiated.

In this case, it is preferable that the method for processing further includes correcting the processing shape on the body 80 to be irradiated to the pattern on the mask 21 based on the information of the alignment mechanism.

With such a method for processing, it is possible to perform a more accurate recesses and protrusions processing on the substrate. Such a correction can be made, for example, by combining the third optical functional unit 30, the beam image detection camera 70, the sweep mechanism for the mask 21, the sweep mechanism for the substrate stage 80, and the like.

### [Method for Producing Substrate]

In the method for producing a substrate according to the present invention, the substrate is processed by the method for laser processing according to the present invention. With such a method for producing the substrate, a plurality of irradiations can be performed with uniform processing depth of the substrate irradiation area in the substrate corresponding to the mask irradiation area that is a portion of the effective area of the mask, and thus, a nearly uniform recesses and protrusions processing can be accurately performed across the region to be processed of the substrate. Therefore, according to the method for producing the substrate in this aspect, the substrate, in which fine recesses and protrusions are formed across the region to be processed of the substrate with high accuracy, can be produced.

Moreover, such a method for producing the substrate does not require the use of high laser energy. This method can also be configured inexpensively without using an expensive laser source or optical members, and can suppress the deterioration of accuracy due to thermal drift of the laser beam, which enables producing the substrate processed with high accuracy.

In particular, with the method for producing the substrate, in which the method for processing in the first aspect described above is performed, the superimposed irradiation described above is performed during the processing operation on the substrate, and thus, the deep VIA forming process and/or trench forming process can be performed at high speed. In addition, the substrate irradiation area for one shot can be made small, and this makes high-density irradiation possible.

Moreover, with the method for producing the substrate in which the method for processing in the third aspect described above is performed, since the above-described synchronous sweep irradiation with the irradiation position of the laser beam being fixed is performed during the processing operation on the substrate, the processing can be performed with higher accuracy than in the case of scanning with the laser beam. Furthermore, with such a method for processing, the large-area mask can also be used, and thus, the processing can also be performed at a higher energy density.

The method for producing the substrate of the present invention can be applied particularly advantageously to produce a semiconductor package.

### [Method for Installing Laser Processing Apparatus]

Next, a method for installing a laser processing apparatus according to the present invention will be described, in which the laser processing apparatus includes the laser irradiation apparatus and the irradiation processing unit provided with the stage configured to hold the body to be irradiated. For example, as shown in FIG. 8, the laser processing apparatus can be made separable by providing the detachable unit 300A between the second optical functional unit 20 and a first optical function 10, the detachable unit 300B between the second optical functional unit 20 and the laser irradiation processing unit 110A, and the like. Furthermore, the first optical functional unit 10, the second optical functional unit 20, and the laser irradiation processing unit 110A are separated and transported to the installation location of the laser processing apparatus 200A, respectively. Subsequently, the laser processing apparatus 200A is assembled and integrated at the installation location of the laser processing apparatus 200A. Thereafter, the mask is installed in the second optical functional unit 20 before or after the transportation by the method for installing a mask described above. With such a method for installing a laser processing apparatus, installation costs can be reduced.

### [Exposure Apparatus]

Moreover, by using the body 80 to be irradiated as a substrate having a resist film on the surface thereof, and configuring the laser irradiation treatment unit 110 shown in FIG. 1 as an exposure processing unit 110B including a stage configured to hold the substrate having the resist film on the surface as the body 80 to be irradiated, an exposure apparatus 200B for performing exposure processing on the resist by irradiation energy of a laser beam can be provided as the laser irradiation treatment apparatus 200. Accordingly, the exposure apparatus is configured such that problems such as the deflection of the mask due to the self-weight of the mask and the adhesion of the particles to the mask are suppressed.

In the exposure apparatus 200B according to the present invention, in the same way as in the laser processing apparatus described above, it is preferable that the second optical functional unit 20, the first optical function 10, and the exposure processing unit 110B are separable from each other. This facilitates the separated transportation and enables the reduction in the installation cost. The exposure apparatus 200B preferably further includes the mask changer 28 capable of installing and removing the mask 21 to and from the second optical functional unit 20. This enables various exposure patterns to be easily formed.

### [Method for Exposure Processing]

By employing the exposure apparatus 200B according to the present invention described above, the exposure processing on the surface of the body 80 to be irradiated can be performed. Consequently, highly accurate exposure processing can be performed while preventing the deformation of the mask and the adhesion of the particles to the mask.

### [Method for Installing Exposure Apparatus]

Next, a method for installing an exposure apparatus according to the present invention will be described, in which the exposure apparatus includes the laser irradiation apparatus and the exposure processing unit provided with the stage configured to hold the body to be irradiated. The method for installing an exposure apparatus according to the present invention is, in the same way as in the method for installing a laser processing apparatus described above, the second optical functional unit 20, the first optical functional unit 10, and the exposure processing unit 110B are made separable from each other by providing the detachable unit 300A, the detachable unit 300B, and the like, as shown in FIG. 8. Then, the first optical functional unit 10, the second optical functional unit 20, and the exposure processing unit 110B are separated and transported to the installation location of the exposure apparatus 200B, respectively. Subsequently, the exposure apparatus 200B is assembled and integrated at the installation location of the exposure apparatus 200B. Thereafter, the mask is installed in the second optical functional unit 20 before or after the transportation by the method for installing a mask described above. With such a method for installing an exposure apparatus, installation costs can be reduced.

As described above, from the viewpoint of suppressing the deflection of the large mask, it is important to arrange the large mask vertically, and other components and steps are optional.

The present description includes the following embodiments.
[1]: A laser irradiation apparatus for irradiating a body to be irradiated with a laser through a mask installed in a second optical functional unit, the apparatus comprising:
   a first optical functional unit comprising a laser source; and
   the second optical functional unit for installing the mask having a pattern corresponding to a laser irradiation region of the body to be irradiated, wherein
   the mask includes an effective area having the pattern corresponding to the laser irradiation region of the body to be irradiated, and is a quadrilateral having an outer edge of the mask formed by four sides, a longest side of which has a length of 800 mm or more, and
   the mask is arranged such that a normal to a surface on which the pattern is formed is oriented in a substantially horizontal direction in the second optical functional unit.
[2]: The laser irradiation apparatus according to the above [1], wherein
   the mask has a thickness of 10 mm or less at the effective area in a laser transmission direction.
[3]: A laser processing apparatus for performing ablation processing on a surface of the body to be irradiated by irradiation energy of a laser beam, the apparatus comprising:
   an irradiation processing unit comprising a stage configured to hold the body to be irradiated; and
   the laser irradiation apparatus according to the above [1] or [2].
[4]: The laser processing apparatus according to the above [3], wherein
   the second optical functional unit, the first optical functional unit, and the irradiation processing unit are separable from each other.
[5]: The laser processing apparatus according to the above [3] or [4], further comprising a mask changer capable of installing and removing the mask to and from the second optical functional unit.
[6]: A method for laser processing on a body to be irradiated, wherein
   ablation processing is performed on the surface of the body to be irradiated using the laser processing apparatus according to any one of the above [3] to [5].
[7]: A method for installing a mask to install the mask in a laser irradiation apparatus for irradiating a body to be irradiated with a laser through the mask installed in a second optical functional unit, the laser irradiation apparatus comprising:
   a first optical functional unit comprising a laser source; and
   the second optical functional unit for installing the mask having a pattern corresponding to a laser irradiation region of the body to be irradiated, wherein
   the mask being used is a quadrilateral having an outer edge formed by four sides, a longest side of which has a length of 800 mm or more, and
   the mask is installed in the second optical functional unit such that a normal to a surface on which the pattern is formed is oriented in a substantially horizontal direction.
[8]: The method for installing a mask according to the above [7], wherein
   a mask having a thickness of 10 mm or less at the effective area in a laser transmission direction is used as the mask.
[9]: The method for installing a mask according to the above [7] or [8], wherein
   the mask is installed using a mask changer.
[10]: A method for installing a laser processing apparatus, the laser processing apparatus including the laser irradiation apparatus and the irradiation processing unit comprising a stage configured to hold the body to be irradiated, wherein
   the second optical functional unit, the first optical functional unit, and the irradiation processing unit are configured to be separable from each other, and the method comprises:
   separately transporting the first optical functional unit, the second optical functional unit, and the irradiation processing unit to an installation location of the laser processing apparatus, respectively;
   assembling the transported units into the laser processing apparatus integrated at the installation location of the laser processing apparatus; and
   installing the mask in the second optical functional unit before or after the transportation according to the method for installing a mask of any one of the above [7] to [9].
[11]: A mask to be vertically installed in a laser irradiation apparatus, the mask having a quadrilateral shape and comprising an effective area that has a pattern corresponding to a laser irradiation region of a body to be irradiated, wherein
   a longest side among four sides of the quadrilateral has a length of 800 mm or more.
[12]: A laser irradiation apparatus for irradiating a body to be irradiated with a laser through a mask installed in a second optical functional unit, the apparatus comprising:
   a first optical functional unit comprising a laser source; and
   the second optical functional unit for installing the mask having a pattern corresponding to a laser irradiation region of the body to be irradiated, wherein
   the mask includes an effective area having the pattern corresponding to the laser irradiation region of the body to be irradiated, and is a quadrilateral having an outer edge of the mask formed by four sides, a shortest side of which has a length of 1000 mm or more, and
   the mask is arranged such that a normal to a surface on which the pattern is formed is oriented in a substantially horizontal direction in the second optical functional unit.
[13]: The laser irradiation apparatus according to the above [12], wherein
   the mask has a thickness of 10 mm or less at the effective area in a laser transmission direction.
[14]: A laser processing apparatus for performing ablation processing on a surface of the body to be irradiated by irradiation energy of a laser beam, the apparatus comprising:
   an irradiation processing unit comprising a stage configured to hold the body to be irradiated; and
   the laser irradiation apparatus according to the above [12] or [13].
[15]: The laser processing apparatus according to the above [14], wherein
   the second optical functional unit, the first optical functional unit, and the irradiation processing unit are separable from each other.
[16]: The laser processing apparatus according to the above [14] or [15], further comprising a mask changer capable of installing and removing the mask to and from the second optical functional unit.
[17]: A method for laser processing on a body to be irradiated, wherein
   ablation processing is performed on the surface of the body to be irradiated using the laser processing apparatus according to any one of the above [14] to [16].
[18]: A laser exposure apparatus for performing exposure processing on the surface of the body to be irradiated by irradiation energy of a laser beam, the apparatus comprising:
   an exposure unit comprising a stage configured to hold the body to be irradiated; and
   the laser irradiation apparatus according to any one of the above [12] or [13].
[19]: The laser exposure apparatus according to the above [18], wherein
   the second optical functional unit, the first optical functional unit, and the exposure unit are separable from each other.
[20]: The laser exposure apparatus according to the above [18] or [19], further comprises a mask changer capable of installing and removing the mask to and from the second optical functional unit.
[21]: A method for laser exposure on a body to be irradiated, wherein
   exposure processing is performed on the surface of the body to be irradiated using the laser exposure apparatus according to any one of the above [18] to [20].
[22]: A method for installing a mask to install the mask in a laser irradiation apparatus for irradiating a body to be irradiated with a laser through the mask installed in a second optical functional unit, the laser irradiation apparatus comprising:
   a first optical functional unit comprising a laser source; and
   the second optical functional unit for installing the mask having a pattern corresponding to a laser irradiation region of the body to be irradiated, wherein
   the mask being used is a quadrilateral having an outer edge formed by four sides, a shortest side of which has a length of 1000 mm or more, and
   the mask is installed in the second optical functional unit such that a normal to a surface on which the pattern is formed is oriented in a substantially horizontal direction.
[23]: The method for installing a mask according to the above [22], wherein
   a mask having a thickness of 10 mm or less at the effective area in a laser transmission direction is used as the mask.
[24]: The method for installing a mask according to the above [22] or [23], wherein
   the mask is installed using a mask changer.
[25]: A method for installing a laser processing apparatus, the laser processing apparatus including the laser irradiation apparatus and the irradiation processing unit comprising a stage configured to hold the body to be irradiated, wherein
   the second optical functional unit, the first optical functional unit, and the irradiation processing unit are configured to be separable from each other, and the method comprises:
   separately transporting the first optical functional unit, the second optical functional unit, and the irradiation processing unit to an installation location of the laser processing apparatus, respectively;
   assembling the transported units into the laser processing apparatus integrated at the installation location of the laser processing apparatus; and
   installing the mask in the second optical functional unit before or after the transportation according to the method for installing a mask of any one of the above [22] to [24].
[26]: A method for installing a laser exposure apparatus, the laser exposure apparatus including the laser irradiation apparatus and the exposure unit comprising a stage configured to hold the body to be irradiated, wherein
   the second optical functional unit, the first optical functional unit, and the exposure unit are configured to be separable from each other, and the method comprises:
   separately transporting the first optical functional unit, the second optical functional unit, and the exposure unit to an installation location of the laser exposure apparatus, respectively;
   assembling the transported units into the laser exposure apparatus integrated at the installation location of the laser exposure apparatus; and
   installing the mask in the second optical functional unit before or after the transportation according to the method for installing a mask of any one of the above [22] to [24].
[27]: A mask to be vertically installed in a laser irradiation apparatus, the mask having a quadrilateral shape and comprising an effective area that has a pattern corresponding to a laser irradiation region of a body to be irradiated, wherein
   a shortest side among four sides of the quadrilateral has a length of 1000 mm or more.
[28]: A laser irradiation system for irradiating a body to be irradiated with a laser through a mask installed in a second optical functional unit, the system comprising:
   a first optical functional unit comprising a laser source; and
   the second optical functional unit for installing the mask having a pattern corresponding to a laser irradiation region of the body to be irradiated, wherein
   the mask includes an effective area having the pattern corresponding to the laser irradiation region of the body to be irradiated, and is a quadrilateral having an outer edge of the mask formed by four sides, a shortest side of which has a length of 1000 mm or more, and
   the mask is arranged such that a normal to a surface on which the pattern is formed is oriented in a substantially horizontal direction in the second optical functional unit.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A laser irradiation apparatus for irradiating a body to be irradiated with a laser through a mask installed in a second optical functional unit, the apparatus comprising:
a first optical functional unit comprising a laser source; and
the second optical functional unit for installing the mask having a pattern corresponding to a laser irradiation region of the body to be irradiated, wherein
the mask includes an effective area having the pattern corresponding to the laser irradiation region of the body to be irradiated, and is a quadrilateral having an outer edge of the mask formed by four sides, a longest side of which has a length of 800 mm or more, and
the mask is arranged such that a normal to a surface on which the pattern is formed is oriented in a substantially horizontal direction in the second optical functional unit.

2. The laser irradiation apparatus according to claim 1, wherein
the mask has a thickness of 10 mm or less at the effective area in a laser transmission direction.

3. A laser processing apparatus for performing ablation processing on a surface of the body to be irradiated by irradiation energy of a laser beam, the apparatus comprising:
an irradiation processing unit comprising a stage configured to hold the body to be irradiated; and
the laser irradiation apparatus according to claim 1.

4. The laser processing apparatus according to claim 3, wherein
the second optical functional unit, the first optical functional unit, and the irradiation processing unit are separable from each other.

5. The laser processing apparatus according to claim 3, further comprising a mask changer capable of installing and removing the mask to and from the second optical functional unit.

6. A method for laser processing on a body to be irradiated, wherein
ablation processing is performed on the surface of the body to be irradiated using the laser processing apparatus according to any one of claims 3 to 5.

7. A method for installing a mask to install the mask in a laser irradiation apparatus for irradiating a body to be irradiated with a laser through the mask installed in a second optical functional unit, the laser irradiation apparatus comprising:
a first optical functional unit comprising a laser source; and
the second optical functional unit for installing the mask having a pattern corresponding to a laser irradiation region of the body to be irradiated, wherein
the mask being used is a quadrilateral having an outer edge formed by four sides, a longest side of which has a length of 800 mm or more, and
the mask is installed in the second optical functional unit such that a normal to a surface on which the pattern is formed is oriented in a substantially horizontal direction.

8. The method for installing a mask according to claim 7, wherein
a mask having a thickness of 10 mm or less at the effective area in a laser transmission direction is used as the mask.

9. The method for installing a mask according to claim 7, wherein
the mask is installed using a mask changer.

10. A method for installing a laser processing apparatus, the laser processing apparatus including the laser irradiation apparatus and the irradiation processing unit comprising a stage configured to hold the body to be irradiated, wherein
the second optical functional unit, the first optical functional unit, and the irradiation processing unit are configured to be separable from each other, and the method comprises:
separately transporting the first optical functional unit, the second optical functional unit, and the irradiation processing unit to an installation location of the laser processing apparatus, respectively;
assembling the transported units into the laser processing apparatus integrated at the installation location of the laser processing apparatus; and
installing the mask in the second optical functional unit before or after the transportation according to the method for installing a mask of any one of claims 7 to 9.

11. A mask to be vertically installed in a laser irradiation apparatus, the mask having a quadrilateral shape and comprising an effective area that has a pattern corresponding to a laser irradiation region of a body to be irradiated, wherein
a longest side among four sides of the quadrilateral has a length of 800 mm or more.
